# EUROPEAN PATENT SPECIFICATION

(11) **EP 1 250 630 B1**
(45) Date of publication and mention of the grant of the patent: **03.12.2008**
(21) Application number: 01977563.4
(22) Date of filing: 05.10.2001
(51) Int. Cl.: G03F 7/20

(54) **Photolithography system with mountable and removable sensor**
Photolithographisches System mit montier- und abnehmbarem Sensor
Système de photolithographie avec capteur montable et amovible

(30) Priority: 05.10.2000 US 679388
(43) Date of publication of application: 23.10.2002
(73) Proprietor: ASML Holding N.V., 5504 DR Veldhoven (NL)
(72) Inventor: CATEY, Eric, B., Danbury, CT 06811 (US); HULT, David, A., Danbuy, Connecticut 06810 (US); ROUX, Stephen, New Fairfield, Connecticut 06812 (US); BEDNAREK, Todd, J., Southbury, CT 06488 (US)
(74) Representative: Grünecker, Kinkeldey, Stockmair & Schwanhäusser Anwaltssozietät
(86) International application number: PCT/US2001/031332
(87) International publication number: WO 2002/029495

(56) References cited:
- EP-A- 0 833 193
- EP-A- 1 139 174
- US-A- 4 585 342
- CAUSEY G.C.; QUINN R.D.: 'Gripper design guidelines for modular manufacturing' PROCEEDINGS OF THE 1998 IEEE INTERNATIONAL CONFERENCE ON ROBOTICS AND AUTOMATION, LEUVEN, BELGIUM, MAY 1998 vol. 2, 16 May 1998, NEW YORK, NY, USA, IEEE, US, pages 1453 - 1458, XP010281214

## Description

### Background of the Invention

### Field of the Invention

The present invention relates generally to photolithography systems. More particularly, the present invention relates to sensors used in photolithography processes.

### Related Art

Lithography is a process used to create features on the surface of substrates. Examples of substrates include those used in the manufacture of flat panel displays, circuit boards, various integrated circuits, and the like. A semiconductor wafer, for example, can be used as a substrate to fabricate an integrated circuit.

During lithography, a reticle is used to transfer a desired pattern onto a substrate. Reticles may be formed of material(s) transparent to the lithographic wavelength being used, for example glass in the case of visible light. In addition, reticles may also be formed of material(s) that reflect the lithographic wavelength being used. The reticle has an image printed on it. The size of the reticle is chosen for the specific system in which it is used. During lithography, an illumination source illuminates a reticle that is disposed on a reticle stage. This illumination exposes an image onto a substrate that is disposed on a substrate stage by a substrate chuck. The image exposed onto the substrate corresponds to the image printed on the reticle.

The projected image produces changes in the characteristics of a layer, for example photoresist, deposited on the surface of the substrate. These changes correspond to the features projected onto the substrate during exposure. Subsequent to exposure, the layer can be etched to produce a patterned layer. The pattern corresponds to those features projected onto the substrate during exposure. This patterned layer is then used to remove exposed portions of underlying structural layers within the substrate, such as conductive, semiconductive, or insulative layers. This process is then repeated, together with other steps, until the desired features have been formed on the surface of the substrate.

Lithography systems require periodic testing and calibration. Generally, such testing and calibration requires the placement of sensors on the substrate stage. Conventional sensors are permanently affixed to a substrate stage. Advanced lithography systems often require a plurality of testing and calibration sensors. Each sensor that is affixed to the stage adds mass, both as a result of the sensor itself, and as a result of additional surface area required to support the sensor. In order to reduce stage mass, certain of these sensors are attached to the stage immediately prior to use, and are removed immediately after use. To utilize such sensors, operation of the lithography system must be interrupted and a technician must manually attach and remove the sensor. This interruption is costly because it is labor-intensive and slow, thereby limiting the time the tool can be used to perform lithography.

Accordingly, what is needed is a sensor apparatus that enables the efficient utilization of sensors.

US 4,585,342 describes a system for real time monitoring the characteristics, variations and alignment errors of lithography structures, and discloses all of the features in the preambel of claim 1.

EP 0833193 describes an exposure apparatus with detachable illumination sensor which is installed on the wafer stage in a freely detachable manner.

EP 1139174, which is considered as belonging to the prior art according to Article 54 (3) EPC, describes an illuminance measurement apparatus and exposure apparatus which includes an illuminance meter detachably attached to the substrate stage.

### Summary of the Invention

The present invention provides a system with and methods for a mountable and removable sensor apparatus as defined in claims 1, 22 and 29.

Preferred embodiments are defined in the dependent claims.

In embodiments of the present invention, the sensor apparatus has one or more alignment markings that enable physical alignment of the sensor with an optical system.

In an embodiment of the present invention, the sensor apparatus includes a communications interface coupled to the sensor. The communications interface enables the sensor to communicate with a data interface when the sensor apparatus is mounted on the stage assembly.

In a further embodiment of the present invention, the sensor apparatus includes a battery that provides power to the sensor.

The present invention also includes methods of mounting a sensor apparatus onto a stage assembly, and a method of removing a sensor apparatus from a stage assembly. These methods involve the engagement of a manipulator with the sensor apparatus.

The present invention advantageously allows automated placement and removal of sensors used for periodic calibration and diagnostics of a semiconductor photolithography machine without special tooling or machine downtime.

The present invention also advantageously reduces stage mass by keeping detectors and electronics off the stage until needed.

Furthermore, the present invention advantageously allows substantial operational time savings. For instance, the replacement of sensors and detectors may be performed without having to take a photolithography system down.

Additionally, the present invention enables sensors and/or detectors, such as calibration standards, to be shared among multiple systems (e.g., multiple photolithography machines within a semiconductor fabrication facility).

### Brief Description of the Figures

The accompanying drawings, which are incorporated herein and form a part of the specification, illustrate the present invention, and together with the description, further serve to explain the principles of the invention and to enable a person skilled in the pertinent art to make and use the invention.
FIG.1 illustrates a functional block diagram, according to an embodiment of the present invention.
FIGS. 2A-2D illustrate an operational sequence involving the placement of a sensor apparatus onto a stage assembly, according to an embodiment of the present invention.
FIGS. 3A-3D illustrate an operational sequence involving the removal of a stage of a sensor apparatus from a stage assembly, according to an embodiment of the present invention.
FIGS. 4A and 4B provide two views of a sensor apparatus, according to an embodiment of the present invention.
FIG. 5 is a view of an implementation of a stage assembly, according to an embodiment of the present invention.
FIG. 6 is a view of a sensor apparatus and a stage assembly in alignment for mounting, according to an embodiment of the present invention.
FIG. 7 is a view of a chuck mountable wafer sensor apparatus, according to an embodiment of the present invention.

The present invention will now be described with reference to the accompanying drawings. In the drawings, like reference numbers indicate identical or functionally similar elements. Additionally, the left-most digit(s) of a reference number identifies the drawing in which the reference number first appears.

### Detailed Description of the Preferred Embodiments

### Overview

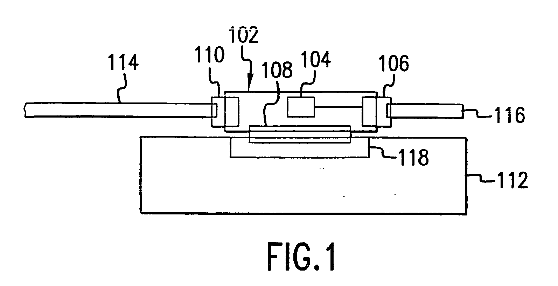

FIG. 1 is a block diagram of a sensor apparatus 102 according to an embodiment of the present invention. Sensor apparatus 102 includes a sensor 104, a communications interface 106 that is coupled to sensor 104, a stage assembly interface 108, and a manipulator interface 110. Sensor apparatus 102 can be mounted on and removed from a mounting interface 118 of a stage assembly 112 by a manipulator 114.

Sensor 104 is a device that receives and responds to input signal(s). In an embodiment of the present invention, sensor 104 responds to input signals and/or stimuli by generating output signal(s). These output signals are transmitted to a data interface 116 when sensor apparatus 102 is mounted on stage assembly 112. Table 1 provides a list of exemplary sensors that can be included in sensor 104. Table 1 also provides a brief description of each of these exemplary sensors. These exemplary sensors are provided as examples, and not as limitations on the scope of the present invention.

| **Table 1** | |
|---|---|
| **Sensor Type** | **Description** |
| Dose detector | Like dose calibration standards, dose detectors measure photon energy emitted by an optics system and provide a way of calibrating lithography tools to output a desired amount of energy. However, dose detectors are generally associated with a single lithography tool machine. Furthermore, dose detectors are typically calibrated with a dose calibration standard that is associated with a set of lithography tools. |
| Dose calibration standard | Dose calibration standards measure photon energy emitted by an optics system. Dose calibration standards provide a way of calibrating lithography tools to output a desired amount of energy. |
| Wavefront sensing detector | Wavefront sensing detectors measure characteristics of light projected by an optics system. Wavefront sensing detectors can identify aberrations created by optics systems, such as astigmatism. Causes of pattern distortions include temperature cycling due to system operation, and system wear. |
| Interferometer | Interferometers measure the relative phase difference between different beams of light. |
| Aerial image sensor | Aerial image sensors detect images projected by optics systems (e.g., photolithography optics) at certain wavelengths, referred to herein as actinic wavelengths. Aerial image sensors can have aperture(s) that detect these images. These apertures can be formed in a mask that can be composed of substances, such as a layer of polysilicon, chrome, and/or other materials that are opaque to actinic wavelength(s). These aperture(s) can be disposed on a surface of a substrate that is typically flat. In an embodiment, aerial image sensors read gratings (e.g., lines) that are projected from a reticle to a wafer plane. When scanned across a projected grating, the aerial image sensor can determine wavefront properties, such as phase shifts. |
| Dose uniformity detector | Dose uniformity detectors measure spatial distribution of energy emitted by an illumination |
| | source. For instance, dose uniformity detectors can identify the existence of areas in a lithographic illumination slot that vary in brightness. |
| Reticle alignment sensor | An alignment sensor determines the alignment of reticles in photolithography systems. In an embodiment, a reticle alignment sensor contains image processing functionality that can read one or more alignment markings that are disposed on a reticle. |

Sensor 104 transmits output signals to data interface 116 through communications interface 106. In an embodiment of the present invention, information is transferred between communications interface 106 and data interface 116 through a channel (not shown) furnished by stage assembly 112. Examples of such a channel include electrical connection(s) provided by conductors such as wires, a computer system bus, a local area network (LAN), and/or other channels that would be apparent to persons skilled in the relevant art(s) from the teachings herein. In further embodiments of the present invention, information is directly transferred between communications interface 106 and data interface 116 through techniques such as wireless radio frequency (RF), infrared (IR) optical communications, and/or other techniques, as would be apparent to persons skilled in the relevant art(s).

Data interface 116 stores and/or processes information received from sensor 104 through communications interface 106. In an embodiment of the present invention, data interface 116 can also output data collected from sensor 104 to a user for analysis. Data interface 116 can be implemented with hardware, software, firmware, or any combination thereof.

Stage assembly interface 108 permits sensor apparatus 102 to be mounted on a stage assembly 112. In an embodiment of the present invention, stage assembly 112 is a wafer stage used in semiconductor photolithography processes. However, in further embodiments of the present invention, stage assembly 112 can be a stage that is used in other types of photolithography. Moreover, stage assembly 112 can be a stage used in reticle writing processes. In addition, stage assembly 112 can be a stage in an inspection system that uses, for example, optical and/or electron microscopes.

Manipulator interface 110 permits sensor apparatus 102 to be coupled to manipulator 114. When sensor apparatus 102 is coupled to manipulator 114, manipulator 114 can control the position of sensor apparatus 102. In addition, manipulator 114 can mount sensor apparatus 102 on stage assembly 112 and remove sensor apparatus 102 from stage assembly 112. In an embodiment of the present invention, manipulator 114 is a robot end effector. However, in further embodiments, manipulator 114 can be other devices, as would be apparent to persons skilled in the relevant art(s).

In photolithography applications, such as those involving Extreme Ultraviolet (EUV) or 157 nanometer wavelengths, certain atmospheric conditions must be maintained in the associated photolithography chambers. For example, EUV applications require a vacuum, and 157 nanometer applications require oxygen free environments. To maintain such environments, while enabling the transfer of material with outside environments, intermediate chambers known as load locks are employed. These load locks maintain isolation between such environments while transferring material. Accordingly, in certain semiconductor photolithography applications, robot end effector 114 transports sensor apparatus 104 between a wafer load lock (not shown) and stage assembly 112.

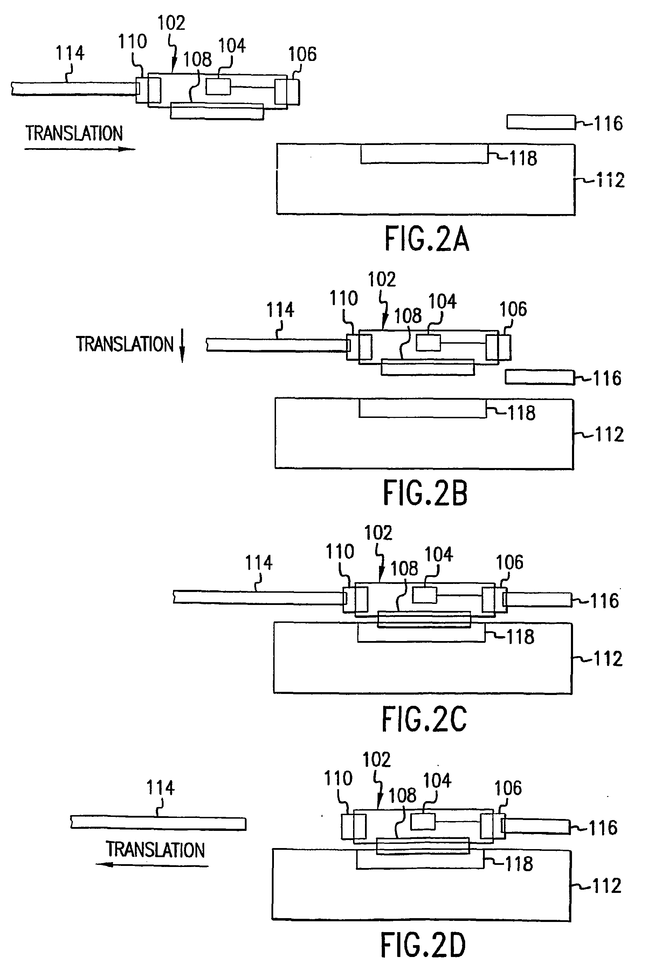

FIGs. 2A-2D illustrate an operational sequence that involves the mounting of sensor apparatus 102 onto stage assembly 112. This mounting operation is controlled by manipulator 114. FIG. 2A illustrates the first step of this sequence. In FIG. 2A, manipulator 114 and sensor apparatus 102 are coupled through manipulator interface 110. In this step, manipulator 114 is moving sensor apparatus 102 towards stage assembly 112 in the direction indicated by the arrow labeled "translation." Manipulator 114 moves sensor apparatus 102 in this direction until it is aligned with stage assembly 112, as shown in FIG. 2B. In an embodiment, this step includes the step of moving sensor apparatus 102 into a photolithography chamber (not shown) through a wafer load lock (not shown), and/or the step of positioning stage assembly 112. This positioning of stage assembly 112 can include rotation and translation of stage assembly 112 in six degrees of freedom. Since stage assemblies in photolithography are capable of making very precise movements, positioning stage assembly 112 can enable a highly accurate alignment between sensor apparatus 102 and stage assembly 112.

FIG. 2B illustrates sensor apparatus 102 in alignment with stage assembly 112. Once aligned, manipulator 114 moves sensor apparatus 102 towards stage assembly 112 in the direction indicated by the arrow labeled "translation." Manipulator 114 moves sensor apparatus 102 in this direction until it is mounted on stage assembly 112.

In FIG. 2C, manipulator 114 has completed the motion described above with reference to FIG. 2B. At this point, sensor apparatus 102 is mounted on stage assembly 112 through stage assembly interface 108 and mounting interface 118. In addition, communications interface 106 is coupled to data interface 116 at this point. In this mounted position, manipulator 114 can decouple itself from sensor apparatus 102.

FIG. 2D illustrates manipulator 114 decoupling itself from sensor apparatus 102. Manipulator 114 performs this decoupling operation by moving away from sensor apparatus 102 and stage assembly 112 in a direction indicated by the arrow labeled "translation." After manipulator 114 has withdrawn from sensor apparatus 102, sensor apparatus 102 can operate.

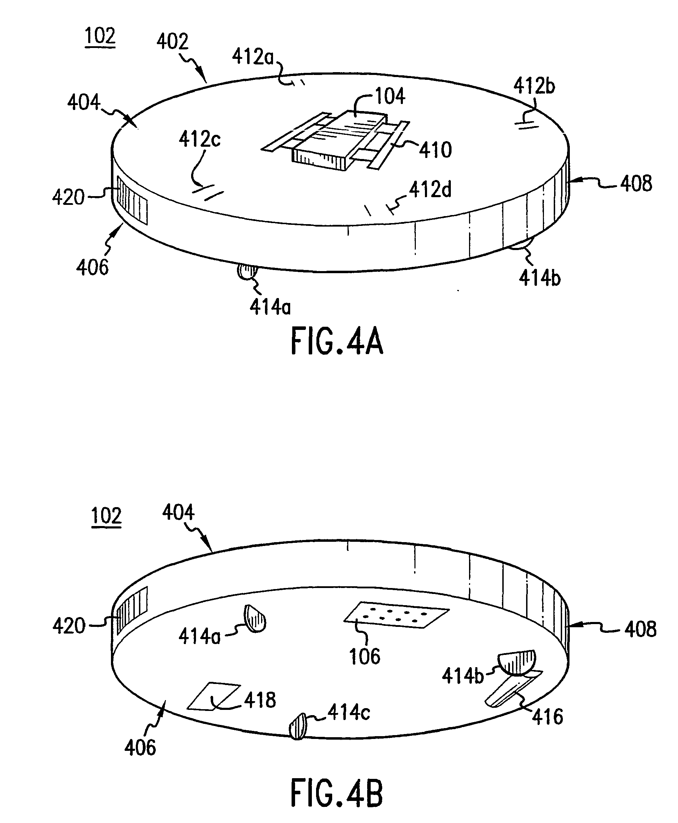

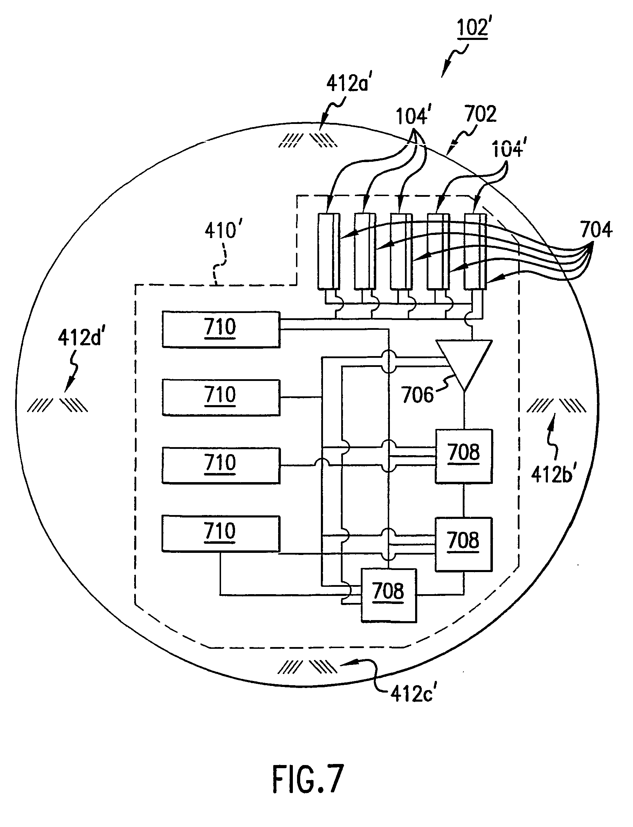

At this point, sensor apparatus 102 is coupled to stage assembly 112. Thus, stage assembly 112 can now position itself to align sensor apparatus 102 with an optical system, for example, photolithography projection optics. In an embodiment, sensor apparatus 102 becomes aligned with an optical system through the use of alignment markings. Such markings are described herein with reference to FIGs. 4A and 7. These alignment markings can be read through the optical system and processed by a controller (not shown). This controller controls the position and alignment of stage assembly 112 relative to an optical reference, such as a reticle, to properly position sensor apparatus 102.

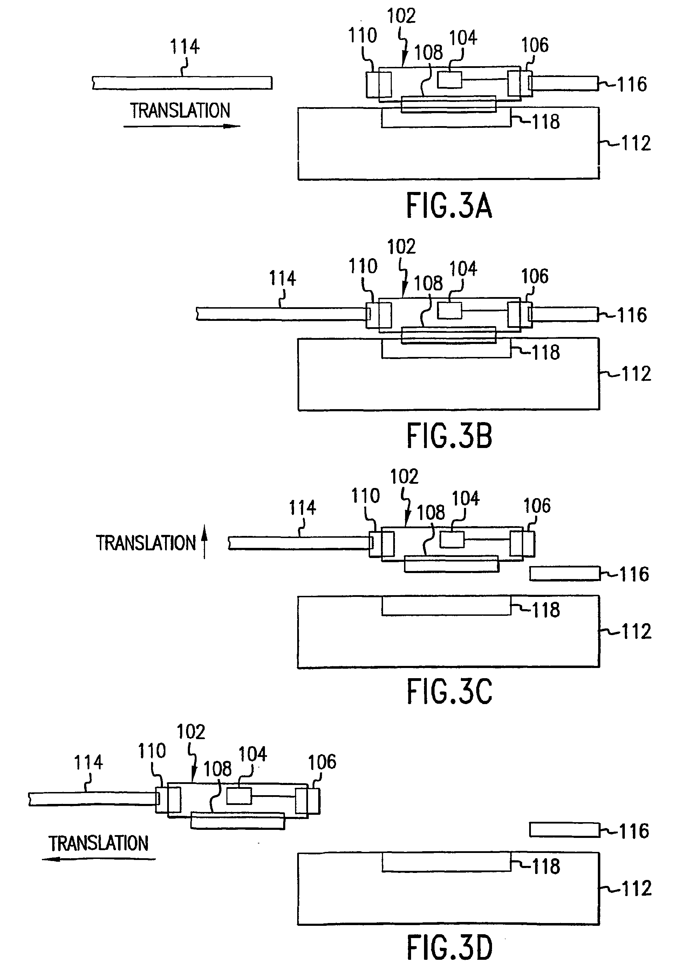

FIGs. 3A-3D illustrate an operational sequence involving the removal of sensor apparatus 102 from stage assembly 112. Like the mounting operation described above with reference to FIGs. 2A-2D, this operation is controlled by manipulator 114.

FIG. 3A illustrates the first step in this sequence. In FIG. 3A, manipulator 114 approaches sensor apparatus 102 in the direction indicated by the arrow labeled "translation." Manipulator 114 continues to approach sensor apparatus 102 until it is coupled with sensor apparatus 102 through manipulator interface 110, as shown in FIG. 3B.

After manipulator 114 is coupled with sensor apparatus 102, manipulator 114 removes sensor apparatus 102 from contact with stage assembly 112, as shown in FIG. 3C. This removal is accomplished by manipulator 114 moving sensor apparatus 102 in the direction labeled "translation." In an embodiment, the step includes manipulator 114 transferring sensor apparatus 106 from a lithography chamber to a storage area (not shown) through a wafer load lock (not shown).

Next, as shown in FIG. 3D, manipulator 114 removes sensor apparatus 102 from the vicinity of stage assembly 112. The direction of this removal is indicated by the arrow labeled "translation."

### Sensor Apparatus

FIGs. 4A and 4B provide two views of an implementation of sensor apparatus 102 according to an embodiment of the present invention. Sensor apparatus 102 comprises a substrate 402 having a first surface 404, a second surface 406, and a third surface ("edge") 408. Surfaces 404 and 406 are substantially parallel and extend to edge 408.

Substrate 402 provides a platform that enables the attachment of sensor components. In embodiments of the present invention, substrate 402 is constructed of a solid material, such as silicon, aluminum, and/or low expansion glass. Moreover, substrate 402 can be constructed of other materials having physical properties suitable for use of sensor apparatus 102, as would be apparent to persons skilled in the relevant art(s).

In further embodiments of the present invention, substrate 402 is implemented with a frame that supports structural plates as first and second surfaces 404 and 406. In this embodiment, edge 408 is implemented as a support ring surrounding the frame. Furthermore, the frame can be braced with honeycombing or a similar structure to increase the stability of substrate 402. An advantage of this frame construction is that it decreases the weight of sensor apparatus 102. Furthermore, such frame construction enables sensor apparatus 102 components to be easily inserted in the interior of substrate 402.

Sensor 104 is disposed on first surface 404. Also disposed on first surface 404 are supporting electronics 410 and a plurality of alignment markings 412a-412d. Sensor 104 can be attached to first surface 404 of substrate 402 by techniques such as soldering and/or bonding. This bonding can be performed with adhesive(s), such as epoxy and/or other adhesives, as would be apparent to persons skilled in the relevant art(s).

Sensor 104 is connected to supporting electronics 410. In an embodiment of the present invention, supporting electronics 410 includes communications functionality that enables information exchange between sensor 104 and data interface 116. Examples of supporting electronics 410 include serial and parallel digital interface logic, as would be apparent to persons skilled in the relevant art(s). Supporting electronics 410 can be implemented with hardware, software, firmware, or any combination thereof.

Alignment markings 412a-412d enable physical alignment of sensor apparatus 102 with an optical system. That is, alignment markings 412 provide a frame of reference to enable stage assembly 112 to set a desired alignment and distance of mounted sensor apparatus 102 from a photolithography system's optics. As illustrated in FIGs. 4A and 4B, alignment markings 412 include pairs of hash marks printed on surface 404 that are oriented at different predetermined angles. In further embodiments of the present invention, alignment markings 412 can include other types of markings printed on surface 404. Examples of such markings include chevrons and other patterns, as would be apparent to persons skilled in the relevant art(s). In addition, alignment markings 412 can be implemented with raised or recessed detents, as would be apparent to persons skilled in the relevant art(s).

Stage assembly interface 108 is disposed on second surface 406. In the embodiment shown in FIGs. 4A and 4B, stage assembly interface 108 includes a plurality of stage assembly connectors 414a-414c.

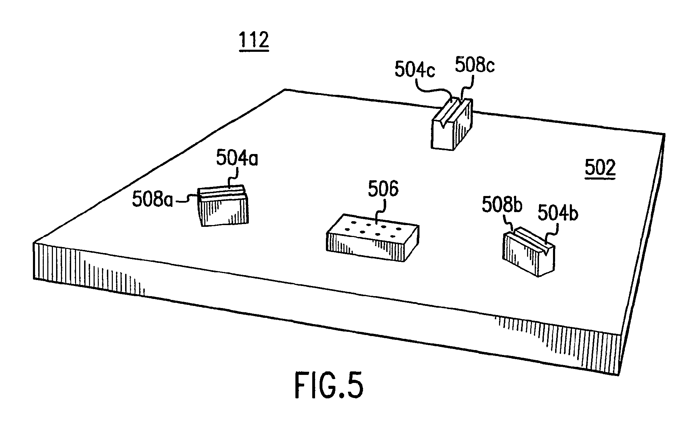

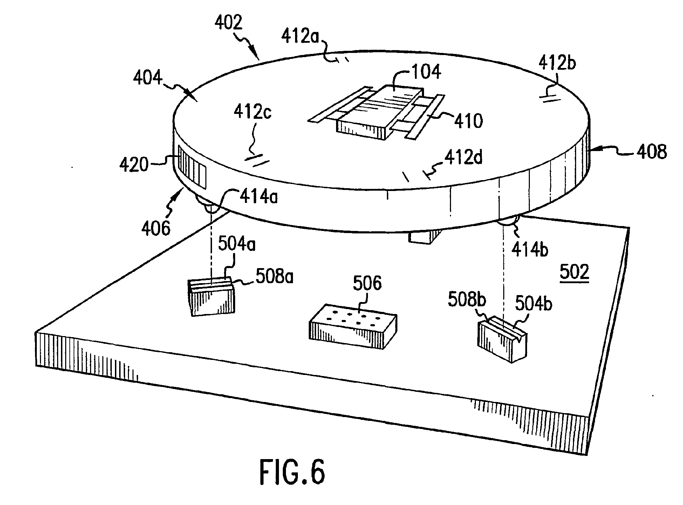

As illustrated in FIGs. 4A and 4B, stage assembly connectors 414a-414c are ball mounts. When sensor apparatus 102 is mounted on stage assembly 112, these ball mounts fit into cradles attached to stage assembly 112, thereby constraining sensor apparatus 102 to the motion of stage assembly 112. These cradles are described below in greater detail with reference to FIGs. 5 and 6. In further embodiments of the present invention, stage assembly interface 108 can be implemented with other techniques to enable the mounting of sensor apparatus 112. Examples of such techniques include the use of magnetic coupling with stage assembly 112, hook mechanisms, and/or other techniques, as would be apparent to persons skilled in the relevant art(s).

Third surface 408 defines a manipulator interface 110. As illustrated in FIGs, 4A and 4B, manipulator interface 110 is an aperture 420 formed on third surface 408 that defines a cavity in substrate 402. Manipulator 114 is coupled with sensor apparatus 102 when an end of manipulator 114 is inserted into aperture 420.

Battery 416 is coupled to sensor 104 and can be disposed on surface 406. Battery 416 provides power to sensor 104. Other elements that can be optionally disposed on surface 406 include communications interface 106, and additional circuitry 418. In further embodiments, battery 416 provides power to other components, such as supporting electronics 410, additional circuitry 418, and communications interface 106. However, in further embodiments of the present invention, communications interface 106 includes a power interface coupled to sensor 104 that permits the transfer of power to sensor 104, supporting electronics 410, and/or additional circuitry 418 when sensor apparatus 102 is mounted on stage assembly 112.

Communications interface 106 is coupled to sensor 104. Communications interface 106 can also be coupled to supporting electronics 410 and additional circuitry 418. In an embodiment of the present invention, communications interface 106 is implemented with spring contact leads that connect to electrical connectors disposed on stage assembly 112. Such electrical connectors are described in greater detail below with reference to FIG. 5. In further embodiments of the present invention, communications interface 106 is implemented with other techniques, such as capacitive and/or inductive coupling to one or more assemblies (e.g., stage assembly 112, and/or other proximate structure), RF communications links, and/or IR communications links, as would be apparent to persons skilled in the relevant art(s). In embodiments, these RF and/or IR communications links can also transfer power to sensor 104, supporting electronics 410, and/or additional circuitry 418.

Like supporting electronics 410, additional circuitry 418 can be connected to sensor 104 to provide features, such as signal conditioning and/or data buffering functionality that enables information exchange between sensor 104 and data interface 116. Additional circuitry 418 can be implemented with hardware, software, firmware, or any combination thereof, as would be apparent to persons skilled in the relevant art(s).

FIG. 5 is a view of an implementation of stage assembly 112, according to an embodiment of the present invention. As illustrated in FIG. 5, stage assembly 112 includes a surface 502, a plurality of sensor apparatus mounts 504a-504c disposed on surface 502, and a connector module 506 disposed on surface 502.

Sensor apparatus mounts 504a-504c are elements of mounting interface 118. Each of the sensor apparatus mounts 504 includes a cradle 508 that corresponds to one of the stage assembly connectors 414. Sensor apparatus mounts 504 constrain sensor apparatus 102 to the motion of stage assembly 112.

Connector module 506 provides a connection between communications interface 106 and data interface 116. Connector module 506 can also provide power to sensor apparatus 102 via communications interface 106. In an embodiment of the present invention, connector module 506 includes a plurality of conductors that correspond to the spring contact leads of communications interface 106. These conductors can be pogo contacts, or other conductors that are apparent to persons skilled in the relevant art(s).

FIG. 6 is a view illustrating alignment of sensor apparatus 102 and stage assembly 112, according to the implementations described above with reference to FIGs. 4 and 5. As illustrated in FIG. 6, stage assembly connectors 414a-c are aligned with corresponding cradles 508a-c.

### Chuck Mountable Wafer Sensor Apparatus

Certain sensors and detectors require substantially flat surfaces to operate. For example, aerial image sensors require substantially flat apertures to properly measure aerial images at discrete focal steps. Unfortunately, the processing needed to create certain sensors and/or detectors (e.g., aerial image sensors) tends to warp the substrate on which the sensor is disposed.

According to an embodiment of the present invention, the function of flattening such warped sensors and/or detectors for proper operation is performed by a wafer chuck.

In photolithography, wafer chucks are mounted to stage assembly 112 and hold wafers, such as semiconductor wafers, flat during exposure. Similarly, a wafer chuck may be used to hold and flatten sensor apparatus 102. Moreover, wafer chucks may be mounted and removed from stage assembly 112 by devices such as manipulator 114. Therefore, according to embodiments of the present invention, sensor apparatus 102 is implemented on a wafer substrate, and mounting interface 118 is implemented with a wafer chuck coupled to stage assembly 112.

FIG. 7 is a view of a chuck mountable wafer implementation of sensor apparatus 102', according to an embodiment of the present invention. Sensor apparatus 102' includes supporting electronics 410', and alignment markings 412a'-412d' disposed on a wafer 702 as a substrate. In addition, sensor apparatus 102' can include the features and elements described herein with reference to sensor apparatus 102.

However, unlike sensor apparatus 102, which includes stage assembly interface 108, in embodiments, sensor apparatus 102' does not include this element. Rather, a wafer chuck (not shown) includes stage assembly interface 108. Thus, in addition to coupling to sensor apparatus 102' and holding sensor apparatus 102' flat, a wafer chuck couples to stage assembly 112.

In an embodiment, sensor apparatus 102' is placed onto stage assembly 112 and removed from stage assembly 112 in accordance with the operational sequences described herein with reference to FIGs. 2A-3D. Such placement and removal can involve manipulator 114 moving sensor apparatus 102' and an attached wafer chuck together. However, such placement and removal can involve manipulator 114 removing and attaching sensor apparatus 102' to a wafer chuck that is already coupled to stage assembly 112.

Supporting electronics 410' may include, but are not limited to, data storage and transmission circuitry 704, signal amplification circuitry 706, signal conditioning circuitry 708, and communications and power transmission circuitry 710. Additionally, supporting electronics 410' can include ground circuitry (not shown). In an embodiment, supporting electronics 410' perform as described herein with reference to supporting electronics 410.

One or more sensors 104' are disposed on wafer 702. As illustrated in FIG. 7, these sensor(s) are aerial image sensors. In an embodiment, these aerial image sensors are composed of photosensitve material with a layer ofpolysilicon, chrome, and/or other materials that are opaque to an actinic wavelength and have an aperture that allows collection of energy from an illumination source. However, in further embodiments of the present invention, sensor(s) 104' can be other types of sensors, as described herein and as would be apparent to persons skilled in the relevant art(s) from the teachings herein.

Sensor(s) 104' are coupled to data storage and transmission circuitry 704, which receives power from communications and power transmission circuitry 710. Data storage and transmission circuitry 704 receives output signals from sensor(s) 104' and transmits these signals to signal amplification circuitry 706.

Signal amplification circuitry 706 amplifies signals received from data storage and transmission circuitry 704 and forwards these signals to signal conditioning circuitry 708. Signal amplification circuitry 706 receives power from communications and power transmission circuitry 710.

Signal conditioning circuitry 708 receives amplified signals and processes these signals so that they are in a format ready to be transmitted to data interface 116 by communications and power transmission circuitry 710. In an embodiment, this format includes digital signals. However, in further embodiments, this format includes analog signals. Signal conditioning circuitry 708 receives power from communications and power transmission circuitry 710.

Communications and power transmission circuitry 710 provides power to other elements of sensor apparatus 102'. In addition, communications and power transmission circuitry 710 transmits signals to data interface 116. In an embodiment, communications and power transmission circuitry 710 includes a battery (not shown) to provide power. However, in further embodiments, communications and power transmission circuitry 710 can receive power through inductive and/or capacitive coupling to one or more assemblies (e.g., stage assembly 112, projection optics (not shown), and/or other proximate structure). In addition, communications and power transmission circuitry 710 can receive power through electrical contacts (not shown) disposed on the surface of wafer 702 that contact a wafer chuck (not shown). These contacts can be disposed on any surface of sensor apparatus 102', so as to enable contact with a wafer chuck.

In embodiments of the present invention, communications and power transmission circuitry 710 exchanges information with data interface 116 through techniques such as capacitive coupling and/or inductive coupling. This coupling can be with stage assembly 112 and/or with projection optics. In addition, communications and power transmission circuitry 710 can communicate information and/or receive power through wireless radio frequency (RF) links, optical (e.g., infrared (IR)) communications, and/or other links, as would be apparent to persons skilled in the relevant art(s).

### Conclusion

While various embodiments of the present invention have been described above, it should be understood that they have been presented by way of example only, and not limitation. It will be apparent to persons skilled in the relevant art(s) that various changes in form and in detail can be made therein without departing from the scope of the invention. Thus, the scope of the present invention should not be limited by any of the above-described exemplary embodiments.

## Claims

1. A photolithography system with a sensor apparatus (102) that is capable of being mounted on and removed from a stage assembly (112), the sensor apparatus (102) comprising:
a substrate (402); and
one or more sensors (104) coupled to said substrate;
**characterized in that**
the sensor apparatus comprises at least one manipulator interface formed as a cavity (110,420) in a side wall surface of the sensor apparatus that permits a manipulator (114) to couple with the sensor apparatus (102) by movement parallel to the stage assembly surface, thereby enabling the manipulator (114) to mount the sensor apparatus (102) on the stage assembly (112) and remove the sensor apparatus (102) from the stage assembly (112).

2. The photolithography system of claim 1, further comprising:
at least one stage assembly connector (414) coupled to said substrate (402) that permits the sensor apparatus (102) to be mounted on a stage assembly (112).

3. The photolithography system of claim 2, wherein each of said at east one stage assembly connectors (414) engages with a mounting interface (118) disposed on the stage assembly (112).

4. The photolithography system of claim 1, wherein said substrate (402) has one or more alignment markings (412a-412d) that enable physical alignment of said sensor (104) with an optical system.

5. The photolithography system of claim 1, further comprising a communications interface (106) coupled to said one or more sensors (104), wherein said communications interface (106) enables said one or more sensors (104) to communicate with a data interface (116) when the sensor apparatus (102) is mounted on the stage assembly (112).

6. The photolithography system of claim 5, wherein said communications interface (106) comprises spring contact leads that connect to electrical connectors disposed on the stage assembly (112).

7. The photolithography system of claim 5, wherein said communications interface (106) comprises a capacitive coupling with the stage assembly (112).

8. The photolithography system of claim 5, wherein said communications interface (106) comprises an inductive coupling with the stage assembly (112).

9. The photolithography system of claim 5, wherein said communications interface (106) comprises an optical communications link.

10. The photolithography system of claim 5, wherein said communications interface (106) comprises a radio frequency (RF) communications link.

11. The photolithography system of claim 1, further comprising a battery coupled to said sensor (104) that provides power to said sensor (104).

12. The photolithography system of claim 1, further comprising a power interface coupled to said one or more sensors (104) that permits the transfer of power to said one or more sensors (104) when the sensor apparatus (102) is mounted on the stage assembly (112).

13. The photolithography system of claim 12, wherein the power interface permits the transfer of power to said one or more sensors (104) through a radio frequency (RF) link.

14. The photolithography system of claim 12, wherein the power interface permits the transfer of power to said one or more sensors (104) through an optical communications link.

15. The photolithography system of claim 1, wherein one of said sensors (104) comprises a wavefront sensing detector.

16. The photolithography system of claim 1, wherein one of said sensors (104) comprises an interferometer.

17. The photolithography system of claim 1, wherein one of said sensors (104) comprises a dose calibration standard.

18. The photolithography system of claim 1, wherein one of said sensors (104) comprises a reticle alignment sensor.

19. The photolithography system of claim 1, wherein one of said sensors (104) comprises a dose uniformity detector.

20. The photolithography system of claim 1, wherein one of said sensors (104) comprises an aerial image sensor.

21. The photolithography system of claim 1, wherein one of said sensors (104) comprises a dose detector.

22. A method of mounting a sensor apparatus (102) onto a stage assembly (112) of a photolithography system, the sensor apparatus (102) including a substrate (402) and one or more sensors (04) coupled to the substrate (402), the method
**characterized by**
the steps of:
engaging a manipulator (114) with a manipulator interface formed as a cavity (110,420) in a side wall surface of the sensor apparatus (102) by movement parallel to the stage assembly surface;
placing the engaged sensor apparatus (102) onto the stage assembly (112); and
disengaging the manipulator (114) from the manipulator interface cavity (110,420) of the sensor apparatus (102).

23. The method of claim 22, further comprising the step of providing at least one stage assembly connector (414) coupled to the substrate (402) that permits the sensor apparatus (102) to be mounted on a stage assembly (112).

24. The method of claim 22, further comprising the step of aligning the placed sensor (102) with an optical system.

25. The method of claim 24, wherein said aligning step comprises the step of positioning the stage assembly (112).

26. The method of claim 22, further comprising the step of aligning the sensor apparatus (102) with the stage assembly (112).

27. The method of claim 26, wherein said aligning step comprises the step of positioning the stage assembly (112).

28. The method of claim 22, further comprising the step of moving the sensor apparatus (102) into a photolithography chamber through a wafer load lock.

29. A method of removing a sensor apparatus (102) from a stage assembly (112), the sensor apparatus (102 including a substrate (402) and one or more sensors (104) coupled to the substrate (402), the method
**characterized by**
the steps of:
engaging a manipulator (114) with a manipulator interface formed as a cavity (110,420) in a side wall surface of the sensor apparatus (102) by movement parallel to the stage assembly surface;
lifting the engaged sensor apparatus (102) from the stage assembly (112); and
moving the engaged sensor apparatus (102) from the stage assembly (112) to a sensor apparatus storage area.

30. The method of claim 29, further comprising the step of providing at least one stage assembly connector (414) coupled to the substrate (402) that permits the sensor apparatus (102) to be mounted on a stage assembly (112).

31. The method of claim 29, further comprising the step of transferring the sensor apparatus (102) from a lithography chamber to a storage area through a wafer load lock.

## Patentansprüche

1. Photolithographiesystem mit einer Sensorvorrichtung (102), die an einer Tischbaugruppe (112) angebracht und von ihr entfernt werden kann, wobei die Sensorvorrichtung (102) umfasst:
einen Träger (402); und
einen oder mehrere Sensoren (104), die mit dem Träger verbunden sind;
**dadurch gekennzeichnet, dass**
die Sensorvorrichtung wenigstens eine Manipulator-Schnittstelle umfasst, die als ein Hohlraum (110, 420) in einer Seitenwandfläche der Sensorvorrichtung ausgebildet ist und Kopplung eines Manipulators (114) mit der Sensorvorrichtung (102) durch Bewegung parallel zu der Oberfläche der Tischbaugruppe ermöglicht, so dass der Manipulator (114) die Sensorvorrichtung (102) an der Tischbaugruppe (112) anbringen kann und die Sensorvorrichtung (102) von der Tischbaugruppe (112) entfernen kann.

2. Photolithographiesystem nach Anspruch 1, das des Weiteren umfasst:
wenigstens einen Tischbaugruppen-Verbinder (414), der mit dem Träger (402) verbunden ist und ermöglicht, dass die Sensorvorrichtung (102) an einer Tischbaugruppe (112) angebracht wird.

3. Photolithographiesystem nach Anspruch 2, wobei jeder von dem wenigstens einen Tischbaugruppen-Verbinder (414) mit einer Anbringungsschnittstelle (118) in Eingriff ist, die an der Tischbaugruppe (112) angeordnet ist.

4. Photolithographiesystem nach Anspruch 1, wobei der Träger (402) eine oder mehrere Ausrichtmarkierungen (412a-412d) aufweist, die physische Ausrichtung des Sensors (104) auf ein optisches System ermöglichen.

5. Photolithographiesystem nach Anspruch 1, das des Weiteren eine Kommunikationsschnittstelle (106) umfasst, die mit dem einen oder den mehreren Sensor/en (104) gekoppelt ist, wobei die Kommunikationsschnittstelle (106) den einen oder die mehreren Sensor/en (104) befähigt, mit einer Datenschnittstelle (116) zu kommunizieren, wenn die Sensorvorrichtung (102) an der Tischbaugruppe (112) angebracht ist.

6. Photolithographiesystem nach Anspruch 5, wobei die Kommunikationsschnittstelle (106) Federkontakt-Zuleitungen umfasst, die mit elektrischen Verbindern verbunden sind, die an der Tischbaugruppe (112) angeordnet sind.

7. Photolithographiesystem nach Anspruch 5, wobei die Kommunikationsschnittstelle (106) eine kapazitive Kopplung mit der Tischbaugruppe (112) umfasst.

8. Photolithographiesystem nach Anspruch 5, wobei die Kommunikationsschnittstelle (106) eine induktive Kopplung mit der Tischbaugruppe (112) umfasst.

9. Photolithographiesystem nach Anspruch 5, wobei die Kommunikationsschnittstelle (106) eine optische Kommunikationsverbindung umfasst.

10. Photolithographiesystem nach Anspruch 5, wobei die Kommunikationsschnittstelle (106) eine Funkfrequenz-Kommunikationsverbindung umfasst.

11. Photolithographiesystem nach Anspruch 1, das des Weiteren eine Batterie umfasst, die mit dem Sensor (104) verbunden ist und dem Sensor (104) Strom bereitstellt.

12. Photolithographiesystem nach Anspruch 1, das des Weiteren eine Stromschnittstelle umfasst, die mit dem einen oder den mehreren Sensor/en (104) gekoppelt ist und die Übertragung von Strom zu dem einen oder den mehreren Sensor/en (104) ermöglicht, wenn die Sensorvorrichtung (102) an der Tischbaugruppe (112) angebracht ist.

13. Photolithographiesystem nach Anspruch 12, wobei die Stromschnittstelle die Übertragung von Strom zu dem einen oder den mehreren Sensor/en (104) über eine Funkfrequenzverbindung ermöglicht.

14. Photolithographiesystem nach Anspruch 12, wobei die Stromschnittstelle die Übertragung von Strom zu dem einen oder den mehreren Sensor/en (104) über eine optische Kommunikationsverbindung ermöglicht.

15. Photolithographiesystem nach Anspruch 1, wobei einer der Sensoren (104) einen Wellenfront-Erfassungsdetektor umfasst.

16. Photolithographiesystem nach Anspruch 1, wobei einer der Sensoren (104) ein Interferometer umfasst.

17. Photolithographiesystem nach Anspruch 1, wobei einer der Sensoren (104) ein Dosis-Eichnormal (dose calibration standard) umfasst.

18. Photolithographiesystem nach Anspruch 1, wobei einer der Sensoren (104) einen Retikel-Ausrichtsensor umfasst.

19. Photolithographiesystem nach Anspruch 1, wobei einer der Sensoren (104) einen Dosis-Einheitlichkeitssensor umfasst.

20. Photolithographiesystem nach Anspruch 1, wobei einer der Sensoren (104) einen Luftbildsensor umfasst.

21. Photolithographiesystem nach Anspruch 1, wobei einer der Sensoren (104) einen Dosisdetektor umfasst.

22. Verfahren zum Anbringen einer Sensorvorrichtung (102) an einer Tischbaugruppe (112) eines Photolithographiesystems, wobei die Sensorvorrichtung (102) einen Träger (402) und einen oder mehrere Sensor/en (104) umfasst, die mit dem Träger (402) verbunden sind, und das Verfahren durch die folgenden Schritte **gekennzeichnet** ist:
Herstellen von Eingriff eines Manipulators (114) mit einer Manipulator-Schnittstelle, die als ein Hohlraum (110, 420) in einer Seitenwandfläche der Sensorvorrichtung (102) ausgebildet ist, durch Bewegung parallel zur Oberfläche der Tischbaugruppe;
Aufsetzen der in Eingriff gebrachten Sensorvorrichtung (102) auf die Tischbaugruppe (112); und
Trennen des Manipulators (114) von dem Hohlraum (110, 420) der Manipulator-Schnittstelle der Sensorvorrichtung (102).

23. Verfahren nach Anspruch 22, das des Weiteren den Schritt des Bereitstellens wenigstens eines Tischbaugruppen-Verbinders (414) umfasst, der mit dem Träger (402) verbunden ist und ermöglicht, dass die Sensorvorrichtung (102) an einer Tischbaugruppe (112) angebracht wird.

24. Verfahren nach Anspruch 22, das des Weiteren den Schritt des Ausrichtens des aufgesetzten Sensors (102) auf ein optisches System umfasst.

25. Verfahren nach Anspruch 24, wobei der Ausrichtschritt den Schritt des Positionierens der Tischbaugruppe (112) umfasst.

26. Verfahren nach Anspruch 22, das des Weiteren den Schritt des Ausrichtens der Sensorvorrichtung (102) auf die Tischbaugruppe (112) umfasst.

27. Verfahren nach Anspruch 26, wobei der Ausrichtschritt den Schritt des Positionierens der Tischbaugruppe (112) umfasst.

28. Verfahren nach Anspruch 22, das des Weiteren den Schritt des Bewegens der Sensorvorrichtung (102) in eine Photolithographiekammer über eine Waferbeschickungsschleuse umfasst.

29. Verfahren zum Entfernen einer Sensorvorrichtung (102) von einer Tischbaugruppe (112), wobei die Sensorvorrichtung (102) einen Träger (402) und einen oder mehrere Sensor/en (104) enthält, die mit dem Substrat (402) verbunden sind, und das Verfahren durch die folgenden Schritte **gekennzeichnet** ist:
Herstellen von Eingriff eines Manipulators (114) mit einer Manipulator-Schnittstelle, die als ein Hohlraum (110, 420) in einer Seitenwandfläche der Sensorvorrichtung (102) ausgebildet ist, durch Bewegung parallel zu der Tischbaugruppen-Oberfläche;
Anheben der in Eingriff gebrachten Sensorvorrichtung (102) von der Tischbaugruppe (112); und
Bewegen der in Eingriff gebrachten Sensorvorrichtung (102) von der Tischbaugruppe (112) zu einem Sensorvorrichtungs-Aufbewahrungsbereich.

30. Verfahren nach Anspruch 29, das des Weiteren den Schritt des Bereitstellens wenigstens eines Tischbaugruppen-Verbinders (414) umfasst, der mit dem Substrat (402) gekoppelt ist und ermöglicht, dass die Sensorvorrichtung (102) an einer Tischbaugruppe (112) angebracht wird.

31. Verfahren nach Anspruch 29, das des Weiteren den Schritt des Überführens der Sensorvorrichtung (102) aus einer Lithographiekammer zu einem Aufbewahrungsbereich über eine Waferbeschickungsschleuse umfasst.

## Revendications

1. Système de photolithographie ayant un dispositif de capteur (102) qui peut être monté sur un ensemble de platine (112) et retiré de celui-ci, le dispositif de capteur (102) comprenant :
un substrat (402) ; et
un ou plusieurs capteurs (104) couplés audit substrat ;
**caractérisé en ce que**
le dispositif de capteur comprend au moins une interface de manipulateur formée comme une cavité (110, 420) dans une surface de paroi latérale du dispositif de capteur qui permet de coupler un manipulateur (114) au dispositif de capteur (102) par un déplacement parallèle à la surface de l'ensemble de platine, en permettant ainsi au manipulateur (114) de monter le dispositif de capteur (102) sur l'ensemble de platine (112) et de retirer le dispositif de capteur (102) de l'ensemble de platine (112).

2. Système de photolithographie selon la revendication 1, comprenant en outre :
au moins un connecteur d'ensemble de platine (414) couplé audit substrat (402) qui permet de monter le dispositif de capteur (102) sur un ensemble de platine (112).

3. Système de photolithographie selon la revendication 2, dans lequel chacun desdits au moins un connecteur d'ensemble de platine (414) vient en prise avec une interface de montage (118) disposée sur l'ensemble de platine (112).

4. Système de photolithographie selon la revendication 1, dans lequel ledit substrat (402) a une ou plusieurs marques d'alignement (412a-412d) qui permettent un alignement physique dudit capteur (104) avec un système optique.

5. Système de photolithographie selon la revendication 1, comprenant en outre une interface de communications (106) couplée auxdits un ou plusieurs capteurs (104), dans lequel ladite interface de communication (106) permet auxdits un ou plusieurs capteurs (104) de communiquer avec une interface de données (116) lorsque le dispositif de capteur (102) est monté sur l'ensemble de platine (112).

6. Système de photolithographie selon la revendication 5, dans lequel ladite interface de communications (106) comprend des fils de contact à ressort qui sont reliés à des connecteurs électriques disposés sur l'ensemble de platine (112).

7. Système de photolithographie selon la revendication 5, dans lequel ladite interface de communications (106) comprend un couplage capacitif avec l'ensemble de platine (112).

8. Système de photolithographie selon la revendication 5, dans lequel ladite interface de communications (106) comprend un couplage inductif avec l'ensemble de platine (112).

9. Système de photolithographie selon la revendication 5, dans lequel ladite interface de communications (106) comprend une liaison de communications optique.

10. Système de photolithographie selon la revendication 5, dans lequel ladite interface de communications (106) comprend une liaison de communications radiofréquence (RF).

11. Système de photolithographie selon la revendication 1, comprenant en outre une batterie couplée audit capteur (104) qui délivre de la puissance audit capteur (104).

12. Système de photolithographie selon la revendication 1, comprenant en outre une interface de puissance couplée auxdits un ou plusieurs capteurs (104) qui permet le transfert de puissance vers lesdits un ou plusieurs capteurs (104) lorsque le dispositif de capteur (102) est monté sur l'ensemble de platine (112).

13. Système de photolithographie selon la revendication 12, dans lequel l'interface de puissance permet le transfert de puissance vers lesdits un ou plusieurs capteurs (104) par l'intermédiaire d'une liaison radiofréquence (RF).

14. Système de photolithographie selon la revendication 12, dans lequel l'interface de puissance permet le transfert de puissance vers lesdits un ou plusieurs capteurs (104) par l'intermédiaire d'une liaison de communications optique.

15. Système de photolithographie selon la revendication 1, dans lequel l'un desdits capteurs (104) comprend un détecteur de détection de front d'onde.

16. Système de photolithographie selon la revendication 1, dans lequel l'un desdits capteurs (104) comprend un interféromètre.

17. Système de photolithographie selon la revendication 1, dans lequel l'un desdits capteurs (104) comprend un étalon de calibrage de dose.

18. Système de photolithographie selon la revendication 1, dans lequel l'un desdits capteurs (104) comprend un capteur d'alignement de réticule.

19. Système de photolithographie selon la revendication 1, dans lequel l'un desdits capteurs (104) comprend un détecteur d'uniformité de dose.

20. Système de photolithographie selon la revendication 1, dans lequel l'un desdits capteurs (104) comprend un capteur d'image aérienne.

21. Système de photolithographie selon la revendication 1, dans lequel l'un desdits capteurs (104) comprend un détecteur de dose.

22. Procédé de montage d'un dispositif de capteur (102) sur un ensemble de platine (112) d'un système de photolithographie, le dispositif de capteur (102) incluant un substrat (402) et un ou plusieurs capteurs (402),
le procédé étant **caractérisé par** les étapes de :
mettre en contact un manipulateur (114) avec une interface de manipulateur formée comme une cavité (110, 420) dans une surface de paroi latérale du dispositif de capteur (102) par un déplacement parallèle à la surface de l'ensemble de platine ;
placer le dispositif de capteur en prise (102) sur l'ensemble de platine (112) ; et
libérer le manipulateur (114) de la cavité d'interface de manipulateur (110, 420) du dispositif de capteur (102).

23. Procédé selon la revendication 22, comprenant en outre l'étape de fournir au moins un connecteur d'ensemble de platine (414) couplé au substrat (402) qui permet de monter le dispositif de capteur (102) sur un ensemble de platine (112).

24. Procédé selon la revendication 22, comprenant en outre l'étape d'aligner le capteur placé (102) avec un système optique.

25. Procédé selon la revendication 24, dans lequel l'étape d'alignement comprend une étape de positionner l'ensemble de platine (112).

26. Procédé selon la revendication 22, comprenant de plus l'étape d'aligner le dispositif de capteur (102) avec l'ensemble de platine (112).

27. Procédé selon la revendication 26, dans lequel ladite étape d'alignement comprend l'étape de positionner l'ensemble de platine (112).

28. Procédé selon la revendication 22, comprenant en outre l'étape de déplacer le dispositif de capteur (102) dans une chambre de photolithographie par l'intermédiaire d'un sas de chargement de plaquette.

29. Procédé de retrait d'un dispositif de capteur (102) d'un ensemble de platine (112), le dispositif de capteur (102) incluant un substrat (402) et un ou plusieurs capteurs (104) couplés au substrat (402),
le procédé étant **caractérisé par** les étapes de :
mettre en prise un manipulateur (114) avec une interface de manipulateur formée comme une cavité (110, 420) dans une surface de paroi latérale du dispositif de capteur (102) par un déplacement parallèle à la surface de l'ensemble de platine ;
soulever le dispositif de capteur en prise (102) depuis l'ensemble de platine (112) ; et
déplacer le dispositif de capteur en contact (102) de l'ensemble de platine (112) jusqu'à une zone de stockage de dispositif de capteur.

30. Procédé selon la revendication 29, comprenant en outre l'étape de fournir au moins un connecteur d'ensemble de platine (414) couplé au substrat (402) qui permet de monter le dispositif de capteur (102) sur un ensemble de platine (112).

31. Procédé selon la revendication 29, comprenant en outre l'étape de transférer le dispositif de capteur (102) d'une chambre de lithographie à une zone de stockage par l'intermédiaire d'un sas de chargement de plaquette.
